**Europäisches Patentamt**

**European Patent Office**

**Office européen des brevets**

(11) Veröffentlichungsnummer: **0 134 001**
**B1**

(12) # EUROPÄISCHE PATENTSCHRIFT

(45) Veröffentlichungstag der Patentschrift:
**10.06.87**

(21) Anmeldenummer: **84109250.5**

(22) Anmeldetag: **03.08.84**

(51) Int. Cl.⁴: **G 01 R 21/00,** G 01 R 21/14,
G 01 R 17/06

(54) Elektronischer Elektrizitätszähler mit automatischem Offsetgrössen-Abgleich.

(30) Priorität: **17.08.83 DE 3329760**

(43) Veröffentlichungstag der Anmeldung:
**13.03.85 Patentblatt 85/11**

(45) Bekanntmachung des Hinweises auf die Patenterteilung:
**10.06.87 Patentblatt 87/24**

(84) Benannte Vertragsstaaten:
**AT CH DE FR GB IT LI SE**

(56) Entgegenhaltungen:
**US-A-4 356 450**

**INT. JOURNAL OF ELECTRONICS, Band 48, Nr. 3, März 1980, Seiten 257-269, London, GB; M. MILKOVIC: "A polyphase microelectronic watt-hour meter"**
**RADIO FERNSEHEN ELEKTRONIK, Band 30, Nr. 12, Dezember 1981, Seite 800, Berlin, DE; A. BOGATZ: "Schaltung zur Taktaufbereitung von selbstabgleichenden Verstärkern"**

(73) Patentinhaber: **Siemens Aktiengesellschaft Berlin und München, Wittelsbacherplatz 2, D-8000 München 2 (DE)**

(72) Erfinder: **Schwendtner, Manfred, Dipl.- Ing., St. Gundekar- Strasse 3, D-8501 Schwarzenbruck (DE)**
Erfinder: **Steinmüller, Günter, Dipl.- Ing., Laufamholzstrasse 65, D-8500 Nürnberg (DE)**

## Beschreibung

Die Erfindung betrifft einen elektronischen Elektrizitätszähler mit einem Multiplizierer und einem nachgeschalteten Integrator mit einer Einrichtung zur Offsetgrößenkorrektur, die einen einem Eingang des Multiplizierers vorgeschalteten ersten steuerbaren Schalter steuert.

Bei elektronischen Zählern wird ein Lastbereich zwischen einem kleinsten Meßstrom und einem zulässigen Grenzstrom festgelegt. Der kleinste Meßstrom ergibt sich aus der geforderten Genauigkeit, da bei kleinen Meßströmen der Meßfehler durch Störgrößen - das sind im wesentlichen Offsetspannungen und Offsetströme der an der Multiplikation und Integration beteiligten Bauelemente - ansteigt. Bei üblichen elektronischen Zählern umfaßt der Lastbereich in der Regel einen Bereich kleinster Meßstrom zu Grenzstrom von 1:100. Wenn man den Lastbereich z.B. auf 1:1000 nach unten erweitern will, so beeinträchtigen insbesondere veränderliche Störgrößen, wie z.B. temperaturabhängige Offsetspannung und Offsetstrom und Langzeitdrift die Genauigkeit.

Aus dem "Internationalen Journal of Electronics", Band 48, Nr. 3, März 1980, Seiten 257 bis 269, ist ein elektronischer Elektrizitätszähler der eingangs genannten Art bekannt, bei dem eine Offsetgrößen-Korrektur dadurch erreicht wird, daß ein Integrator die Impulse eines vorgeschalteten Multiplizierers abwechselnd in positiver oder negativer Richtung integriert. Der Wechsel der Integrationsrichtung wird durch Umschaltung der Polarität eines Eingangssignals des vorgeschalteten Multiplizierers erreicht. Diese Art der Offsetgrößen-Korrektur ist jedoch nur bei der dargestellten speziellen Ausführung eines Integrators anwendbar. Außerdem bleibt, wie auch in der genannten Literaturstelle dargestellt wird, eine verbleibende Offsetgröße, die nicht nur auf Nebeneffekten beruht, sondern aus prinzipiellen Gründen nicht zu vermeiden ist.

Aufgabe der Erfindung ist es daher, einen elektronischen Elektrizitätszähler der eingangs genannten Art so auszugestalten, daß Meßfehler durch Offsetgrößen weiter verringert werden und daß die Offsetspannungskompensation nicht an die spezielle Art der Integration gebunden ist.

Diese Aufgabe wird erfindungsgemäß dadurch gelöst, daß mindestens ein Eingang des Multiplizierers durch den ersten steuerbaren Schalter mit dem Bezugspotential verbindbar ist, daß der Integrationskondensator des Integrators durch einen zweiten steuerbaren Schalter überbrückbar ist, daß eine steuerbare Kompensationseinrichtung zur Kompensation von Offsetspannungen bzw. Offsetströmen des Multiplizierers und des Integrators vorgesehen ist, daß der Ausgang des Integrators mit einem Nullspannungskomparator verbunden ist, dessen Ausgang mit dem Steuereingang der Kompensationseinrichtung verbunden ist und daß eine Steuereinheit in bestimmten Zeitabständen für eine Zeit Δ t die beiden Schalter schließt, wobei während dieser Zeit Δ t der Nullspannungskomparator die Kompensationseinrichtung so steuert, daß die Ausgangsspannung des Integrators Null wird.

In regelmäßigen Zeitabständen werden also die Offsetgrößen des elektronischen Elektrizitätszählers wieder neu kompensiert. Damit führen Änderungen der Offsetgrößen nicht zu einem wesentlichen Meßfehler, so daß der Lastbereich des Zählers nach unten erweitert werden kann.

Die Kompensationseinrichtung kann einen Vor- Rückwärtszähler aufweisen, dessen Ausgänge mit einem Widerstandsnetzwerk so verbunden sind, daß der Gesamtwiderstand des Widerstandsnetzwerks vom Zählerstand des Vor- Rückwärtszählers abhängt, wobei ein Anschlußpunkt des Widerstandsnetzwerks mit einem Eingang des Integrators verbunden ist, wobei der Takteingang des Vor- Rückwärtszählers über eine Verriegelungsstufe mit einem Taktgeber verbunden ist und wobei der Vor- Rückwärtssteuereingang des Vor- Rückwärtszählers vom Nullspannungskomparator angesteuert wird. Mit einer derartigen Schaltungsanordnung kann mit handelsüblichen Bauelementen eine steuerbare Kompensationseinrichtung aufgebaut werden.

In einer vorteilhaften Ausführungsform kann ein Taktgeber in festen Zeitabständen ein erstes Flip-Flop setzen, dessen Setzausgang die beiden Schalter und die Verriegelungsstufe steuert. Dieses Flip-Flop bleibt während des Kompensationsvorgangs gesetzt und hält damit die beiden Schalter geschlossen und gibt die Verriegelungsstufe frei.

Bei einer weiteren vorteilhaften Ausführungsform setzt ein Taktgeber in festen Zeitabständen ein erstes Flip-Flop, wobei dem Nullspannungskomparator ein Flankendetektor nachgeschaltet ist, wobei der Ausgang des ersten Flip-Flops und der Ausgang des Flankendetektors mit den Eingängen eines UND-Gatters verbunden sind und wobei der Ausgang des UND-Gatters mit einem Eingang eines zweiten Flip-Flops verbunden ist, das die beiden Schalter ansteuert. Damit wird erreicht, daß ein vom Taktgeber ausgelöster Kompensationsvorgang erst dann ausgeführt wird, wenn die Ausgangsspannung des Integrators durch Null geht. Damit wird erreicht, daß das Kurzschließen des Integrationskondensators keinen Fehler verursacht.

Der Flankendetektor kann mit einem ersten Eingang eines dritten Flip-Flops verbunden sein, dessen zweiter Eingang über ein Verzögerungsglied mit einem Ausgang des zweiten Flip-Flops verbunden ist, wobei der dem ersten Eingang zugeordnete erste Ausgang des dritten Flip-Flops die Verriegelungsstufe steuert und wobei der dem zweiten Eingang zugeordnete zweite Ausgang mit den Rücksetzeingängen des ersten und des zweiten Flip-Flops verbunden ist. Bei einer derartigen Schaltungsanordnung wird der Kompensationsvorgang sofort abgebrochen, sobald die Ausgangsspannung des Integrators auf Null eingestellt ist.

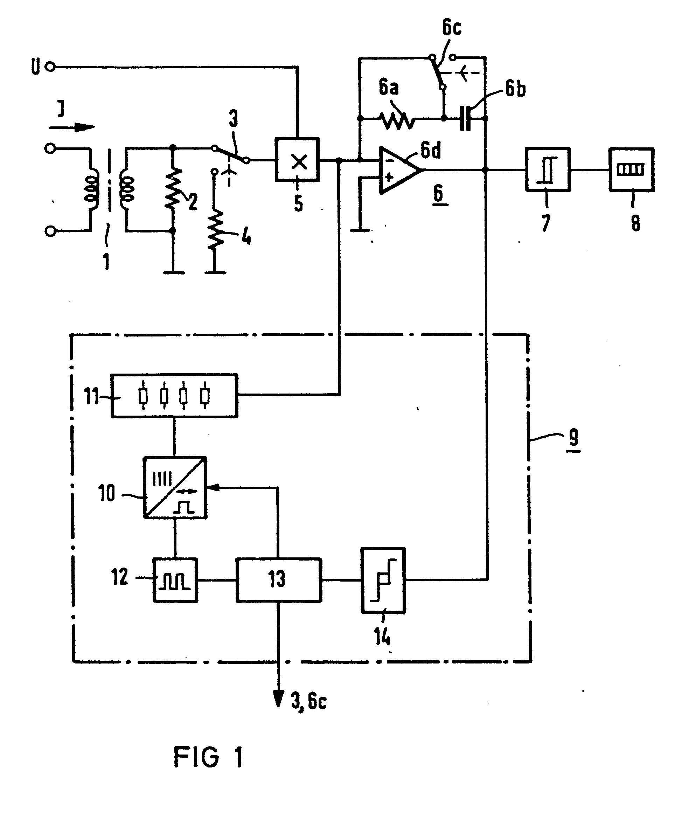

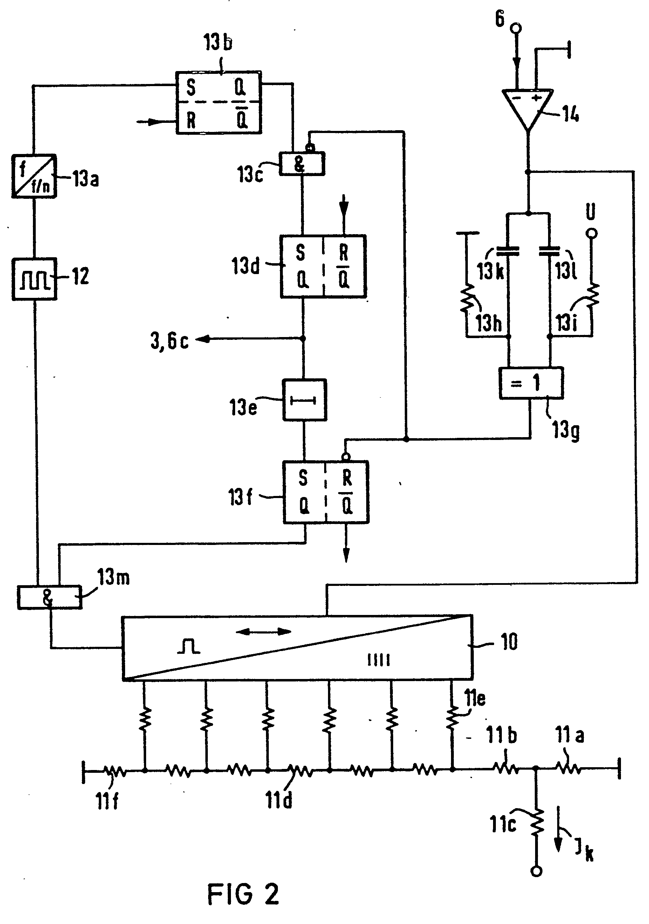

Ein Ausführungsbeispiel der Erfindung wird nachfolgend anhand der Figuren 1 und 2 näher erläutert.

Fig. 1 zeigt ein Blockschaltbild eines elektronischen Elektrizitätszählers mit einem automatischen Offsetabgleich. Der Meßstrom I wird dem Elektrizitätszähler über einen Stromwandler 1 zugeführt, dessen Sekundärseite mit einem Bürdenwiderstand 2 beschaltet ist. Damit wird der zur Verfügung stehende Meßstrom I in eine für die Elektronik geeignete Spannung umgesetzt. Diese Spannung wird einem Umschaltkontakt eines Umschalters 3 zugeführt, dessen zweiter Umschaltkontakt über einen Widerstand 4 an Bezugspotential liegt. Der Umschalter 3 verbindet je nach seiner Schaltstellung den Stromwandler 1 oder den Widerstand 4 mit dem Stromeingang eines Multiplizierers 5, an dessen zweitem Eingang die Meßspannung U ansteht. Im Normalbetrieb steht der Umschalter 3 in der dargestellten Stellung, wobei der Multiplizierer 5 durch Multiplikation von Strom und Spannung die Leistung bildet.

Der Ausgang des Multiplizierers 5 ist mit einem Integrator 6 verbunden. Dieser besteht aus einem Operationsverstärker 6d, der in einem Rückkopplungszweig die Reihenschaltung eines Widerstandes 6a und eines Kondensators 6b aufweist. Über einen Umschalter 6c ist entweder der Widerstand 6a oder der Kondensator 6b überbrückbar. Im Meßbetrieb ist der Umschalter 6c in der dargestellten Position, d.h. der Widerstand 6a ist kurzgeschlossen und die Anordnung arbeitet als reiner Integrator. Dem Integrator 6 ist ein Komparator 7 mit einer Zähleinrichtung 8 nachgeschaltet. Der Komparator 7 bildet zusammen mit dem Integrator 6 einen Quantisierer, mit dem das leistungsproportionale Ausgangssignal des Multiplizierers 5 in eine proportione Frequenz umgewandelt wird.

Die Funktionsweise von Multiplizierer 5 und Quantisierer 6, 7 sind in der Zeitschrift "Technisches Messen atm" 1978, Heft 11, Seiten 407 bis 411, näher erläutert, so daß sich ein näheres Eingehen auf diese Schaltungen hier erübrigt. Das Blockschaltbild nach Fig. 1 zeigt einen einphasigen Elektrizitätszähler. Bei einem dreiphasigen Elektrizitätszähler ist der Eingangskreis bis einschließlich zum Multiplizierer 5 dreifach vorhanden.

Wie bereits erwähnt, haben die im Multiplizierer 5 und im Integrator 6 enthaltenen Operationsverstärker Offsetspannungen, und -ströme die die Meßgenauigkeit bei kleinen Meßströmen beeinträchtigen. Diese Offsetgrößen können zwar durch Abgleich des elektronischen Elektrizitätszählers kompensiert werden, sie sind jedoch temperaturabhängig und unterliegen einer Langzeitdrift. Aus diesem Grunde ist erfindungsgemäß ein automatischer, sich ständig wiederholender Offsetabgleich vorgesehen. Die dafür benötigte Abgleichvorrichtung 9 ist in Fig. 1 in Form eines Blockschaltbildes dargestellt. Die Abgleichvorrichtung 9 wird von einer Steuereinheit 13 gesteuert. Dabei löst ein Taktgeber 12 in bestimmten Zeitabschnitten über die Steuereinheit 13 einen Impuls aus, der die Schalter 3 und 6c umschaltet. Der Meßvorgang wird also damit unterbrochen und dem Stromeingang des Multiplizierers 5 die Spannung Null zugeführt. Außerdem wird der Operationsverstärker 6 als Proportionalverstärker geschaltet. Am Ausgang des Operationsverstärkers 6 kann damit der durch Offsetgrößen des Multiplizierers 5 und des Operationsverstärkers 6 verursachte Nullpunktsfehler erfaßt werden. Die Ausgangsspannung des Operationsverstärkers 6 wird einem Nullspannungskomparator 14 zugeführt, dessen Ausgangssignal davon abhängt, ob die anstehende Spannung größer oder kleiner Null ist. In Abhängigkeit vom Ausgangssignal des Nullspannungskomparators 14 wird über die Steuereinheit 13 ein Zähler 10 in Vorwärts- oder Rückwärtszählrichtung umgeschaltet. Der Takteingang des Zählers 10 ist mit dem Taktgeber 12 verbunden. An den Zählausgängen des Zählers 10 ist ein Widerstandsnetzwerk 11 angeschlossen, dessen Gesamtwiderstand durch den Zählerstand in entsprechenden Stufen veränderlich ist. Mit Hilfe des Widerstandsnetzwerks 11 wird wiederum ein Strom erzeugt, die dem invertierenden Eingang des Operationsverstärkers 6 zugeführt wird. Dieser Strom wird über den Zähler 10 und das Widerstandsnetzwerk 11 solange verändert, bis am Ausgang des Operationsverstärkers 6 die Spannung Null ansteht. Damit sind also die Offsetgrößen des Multiplizierers 5 und des Integrators 6 kompensiert. Die Steuereinheit 13 schaltet die Umschalter 3 und 6c wieder in ihre Normalstellung, so daß wieder der Meßbetrieb aufgenommen wird.

Der Zeitabstand zwischen zwei Kompensationsvorgängen wird so gewählt, daß in diesen Zeitabständen weder durch Temperaturabhängigkeit noch durch Langzeitdrift der Offsetgrößen wesentliche Fehler entstehen können. Beispielsweise kann alle 10 Sekunden ein Meßvorgang stattfinden.

Um nicht vernachlässigbare Fehler durch Unterbrechung des Meßvorgangs zu vermeiden, muß die Dauer eines Kompensationsvorgangs kurz sein gegenüber der Zeitspanne zwischen zwei Kompensationsvorgängen.

Durch die laufende Kompensation von Störgrößen kann bei gleichbleibenden Fehlergrenzwerten der Meßbereich des elektronischen Elektrizitätszähler deutlich, z.B. um den Faktor 10 nach unten erweitert werden. Bei niedrigen Lastpunkten zeigt ein derartig ausgestatteter elektronischer Elektrizitätszähler eine bessere Langzeitstabilität.

Ein Ausführungsbeispiel für den Aufbau einer automatischen Offsetabgleichvorrichtung 9 ist in Fig. 2 dargestellt. Der Taktgeber 12 ist über einen Frequenzteiler 13a mit dem Setzeingang eines ersten taktflankengesteuerten RS-Flip-Flops 13b verbunden. Das Flip-Flop 13b wird also periodisch gesetzt, wobei die Periode von der Frequenz des Taktgebers 12 und dem Teilerverhältnis des Frequenzteilers 13a abhängt. Mit dem Setzen des Flip-Flops 13b wird jeweils ein Offsetabgleichvorgang eingeleitet. Um einen Meßfehler durch Kurzschließen des aufgeladenen Integrationskondensators 6b zu vermeiden, soll jedoch der Offsetabgleichvorgang erst erfolgen, wenn die Ausgangsspannung des Integrators 6 durch Null geht. Die Schalter 3 und 6c werden daher nicht über das erste Flip-Flop 13b direkt, sondern über ein zweites Flip- Flop 13d angesteuert. Das Flip-Flop 13d wird über die im folgenden beschriebene Schaltung gesetzt.

Das Ausgangssignal des Integrators 6 wird dem invertierenden Eingang eines Operationsverstärkers 14 zugeführt, dessen nichtinvertierender Eingang mit dem Bezugspotential verbunden ist. Der Operationsverstärker 14 wirkt damit als Nullspannungskomparator. Dem Operationsverstärker 14 ist ein Flankendetektor nachgeschaltet. Dieser besteht aus zwei Kondensatoren 13k und 13l, die einerseits mit dem Ausgang des Operationsverstärkers 14 und andererseits mit je einem Eingang eines Exclusiv-ODER-Gatters 13g verbunden sind. Ferner ist ein Eingang des Exclusiv-ODER-Gatters 13g über einen Widerstand 13h an Bezugspotential und der zweite Eingang über einen Widerstand 13i an eine positive Spannung u gelegt. Am Ausgang des Exclusiv-ODER-Gatters 13e steht im stationären Zustand eine "1" an, da nur einer der beiden Eingänge auf "1" liegt. Wenn jedoch am Ausgang des Operationsverstärkers 14 ein Signalwechsel stattfindet, so erhalten über die Kondensatoren 13k und 13l kurzzeitig beide Eingänge dasselbe Signal. Damit steht also bei jedem Signalwechsel am Ausgang des Komparators 14, d.h. bei jedem Nulldurchgang des Ausgangssignals des Integrierers 6 am Ausgang des Exclusiv-ODER-Gatters 13g für kurze Zeit ein "0"-Signal an. Dieses wird dem invertierenden Eingang eines UND-Gatters 13c zugeführt, dessen zweiter Eingang mit dem Setzausgang des ersten Flip-Flop's 13b verbunden ist. Der Ausgang des UND-Gatters 13c ist mit dem Setzeingang des zweiten taktflankengesteuerten Flip-Flops 13d verbunden. Der Setzausgang des zweiten Flip-Flops 13d steuert die Schalter 3 und 6c. Eine Umschaltung des elektronischen Elektrizitätszählers auf einen Offsetspannungsabgleich wird also immer dann vorgenommen, wenn erstens eine durch den Taktgeber 12 und den Frequenzteiler 13a vorgegebene Zeit abgelaufen ist und wenn zweitens die Ausgangsspannung des Integrators 6 Null ist. Da diese Ausgangsspannung stets zwischen positiven und negativen Werten wechselt, findet ein solcher Nulldurchgang immer statt. Gegebenenfalls muß dies mit einer Kompensationsschaltung sichergestellt werden, wie sie in der DE-PS 2 128 883 in Spalte 5 und 6 beschrieben ist.

Mit dem Setzausgang des zweiten Flip-Flops 13d ist außerdem über eine Verzögerungsstufe 13e der Setzeingang eines dritten taktflankengesteuerten Flip-Flops 13f verbunden. Der Setzausgang des dritten Flip-Flops 13f ist mit einem Eingang eines UND-Gatters 13m verbunden, mit dessen zweiten Eingang der Taktgeber 13 verbunden ist. Der Ausgang des UND-Gatters 13m ist schließlich mit dem Takteingang eines Zählers 10 verbunden. Kurze Zeit nach Umschaltung der Schalter 3 und 6c werden also Zählimpulse für den Zähler 10 freigegeben. Über diesen erfolgt eine Kompensation der Offsetspannungen, wie im folgenden erläutert wird.

Der Zähler 10 weist einen Vor- Rückwärts-Steuereingang auf, der mit dem Ausgang des Operationsverstärkers 14 verbunden ist. Je nachdem ob die Offsetspannungen einen positiven oder negativen Fehler verursachen, werden also die Impulse des Taktgenerators 12 vorwärts oder rückwärts gezählt. Es ist eine Reihenschaltung von Widerständen 11d vorgesehen, wobei die Verbindungspunkte der Widerstände 11d jeweils über weitere Widerstände 11e mit den Ausgängen des Zählers 10 verbunden sind. Diese Reihenschaltung ist einerseits über einen Widerstand 11f an das Bezugspotential und andererseits über Widerstände 11a und 11b direkt an das Bezugspotential angeschlossen. Die Widerstandswerte der Widerstände 11e und 11f sind doppelt so groß wie die Widerstände 11e. Der Verbindungspunkt der Widerstände 11a und 11b ist über einen Widerstand 11c mit dem Eingang des Integrators 6 verbunden und speist in diesem einen Strom $I_K$. Dieser Strom $I_K$ ist von den an den Ausgängen des Zählers 10 anstehenden Signalen, d.h. also vom Zählerstand des Zählers 10 abhängig. Durch die oben angegebene Dimensionierung der Widerstände 11e und 11f wird ein linearer Zusammenhang zwischen dem Zählerstand des Zählers 10 und dem Strom $I_K$ erreicht. Wenn beispielsweise nach Umschaltung der Schalter 3 und 6c am Ausgang des Integrators 6 eine positive Fehlerspannung auftritt, so wird der Zähler 10 in Vorwärtszähleinrichtung geschaltet. Durch Erhöhung des Zählerstandes wird auch der Strom I erhöht, bis die Fehlerspannung auf Null zurückgeht, d.h. die Offsetgrößen kompensiert sind. Der Abgleichvorgang muß dann beendet werden. Dies erfolgt über das dritte Flip-Flop 13f. Dessen Rücksetzeingang ist mit dem Ausgang des Exclusiv-ODER-Gatters 13g verbunden. Das Flip-Flop 13f wird zurückgesetzt, sobald das Ausgangssignal des Exclusiv-ODER-Gatters 13g eine negative Flanke aufweist, d.h. sobald das Ausgangssignal des Integrators 6 Null wird. Das Flip-Flop 13f wird also zurückgesetzt, sobald die Offsetspannungskompensation durchgeführt ist, wobei das Eins-Signal am Setzausgang des Flip-Flops 13f verschwindet und damit die Taktimpulse für den Zähler 10 blockiert werden. Dieser bleibt damit auf seinem Zählerstand, mit dem gerade eine Kompensation der Offsetspannungen erreicht worden ist, stehen. Der Rücksetzausgang des Flip-Flops 13f ist mit den Rücksetzeingängen der Flip-Flops 13b und 13d verbunden, so daß diese nach Beendigung des Abgleichvorgangs zurückgesetzt werden. Die erreichte Kompensation der Offsetspannungen bleibt erhalten, bis diese sich beispielsweise durch Temperatureinflüsse oder Langzeittrift wieder ändern. Da der beschriebene Abgleich jedoch in verhältnismäßig kurzen Zeitabständen, beispielsweise im Abstand von 10 Sekunden, erfolgt, ändern sich die Offsetspannungen zwischen zwei Abgleichvorgängen allenfalls geringfügig. Der durch Offsetspannungen insbesondere bei kleinen Lastpunkten verursachte Fehler bleibt daher klein, so daß der Lastbereich des Zählers nach unten erweitert werden kann.

**Patentansprüche**

1. Elektronischer Elektrizitätszähler mit einem Multiplizierer (5) und einem nachgeschalteten Integrator (6) sowie mit einer Einrichtung zur Offsetgrößenkorrektur, die einen einem Eingang des Multiplizierers (5) vorgeschalteten ersten steuerbaren Schalter (3) steuert,
dadurch gekennzeichnet,
daß mindestens ein Eingang des Multiplizierers (5) durch den ersten steuerbaren Schalter (3) mit dem Bezugspotential verhindbar ist,
daß der Integrationskondensator (6b) des Integrators (6) durch einen zweiten steuerbaren Schalter (6c) überbrückbar ist,
daß eine steuerbare Kompensationseinrichtung (10, 11) zur Kompensation von Offsetspannungen bzw. Offsetströmen des Multiplizierers (5) und des Integrators (6) vorgesehen ist,
daß der Ausgang des Integrators (6) mit einem Nullspannungskomparator (14) verbunden ist, dessen Ausgang mit dem Steuereingang der Kompensationseinrichtung (10, 11) verbunden ist und
daß eine Steuereinheit (13) in bestimmten Zeitabständen für eine Zeit Δt die beiden Schalter (3, 6c) schließt, wobei während dieser Zeit Δt der Nullspannungskomparator (14) die Kompensationseinrichtung (10, 11) so steuert, daß die Ausgangsspannung des Integrators (6) Null wird.
2. Elektronischer Elektrizitätszähler nach Anspruch 1,
dadurch gekennzeichnet,
daß die Kompensationseinrichtung (10, 11) einen Vor- Rückwärtszähler (10) aufweist, dessen Ausgänge mit einem Widerstandsnetzwerk (11) so verbunden sind, daß der Gesamtwiderstand des Widerstandsnetzwerks (11) vom Zählerstand des Vor- Rückwärtszählers (10) abhängt, daß ein Anschlußpunkt des Widerstandsnetzwerks (11) mit einem Eingang des Integrators (6) verbunden ist, daß der Takteingang des Vor- Rückwärtszählers (10) über eine Verriegelungsstufe (13m) mit einen Taktgeber (12) verbunden ist und
daß der Vor- Rückwärts-Steuereingang des Vor- Rückwärtszählers vom Nullspannungskomparator (14) angesteuert wird.
3. Elektronischer Elektrizitätszähler nach Anspruch 1 oder 2, dadurch gekennzeichnet, daß ein Taktgeber (12) in festen Zeitabständen ein erstes Flip-Flop (13b) setzt, dessen Setzausgang die beiden Schalter (3, 6c) und die Verriegelungsstufe (13m) steuert.
4. Elektronischer Elektrizitätszähler nach Anspruch 1 oder 2, dadurch gekennzeichnet, daß ein Taktgeber (12) in festen Zeitabständen ein erstes Flip-Flop (13b) setzt,
daß den Nullspannungskomparator (14) ein Flankendetektor (13g bis 13l) nachgeschaltet ist,
daß der Ausgang des ersten Flip-Flops (13b) und der Ausgang des Flankendetektors (13g bis 13l) mit den Eingängen eines UND-Gatters (13c) verbunden sind und daß der Ausgang des UND-Gatters (13c) mit eines Eingang eines zweiten Flip-Flops (13d) verbunden ist, das die beiden Schalter (3, 6c) ansteuert.
5. Elektronischer Elektrizitätszähler nach Anspruch 4, dadurch gekennzeichnet, daß der Flankendetektor (13g bis 13l) mit einem ersten Eingang eines dritten Flip-Flops (13f) verbunden ist, dessen zweiter Eingang über ein Verzögerungsglied (13e) mit einen Ausgang des zweiten Flip-Flops (13d) verbunden ist, daß der dem ersten Eingang zugeordnete erste Ausgang des dritten Flip-Flops (13f) die Verriegelungsstufe (13m) steuert und daß der den zweiten Eingang zugeordnete zweite Ausgang mit den Rücksetzeingängen des ersten und des zweiten Flip-Flops (13b, 13d) verbunden ist.

**Claims**

1. An electronic electricity meter comprising a multiplier (5) whose output is connected to an integrator (6), and comprising a device for offset correction which controls a first controllable switch (3) connected in series with an input of the multiplier (5), characterised in that
at least one input of the multiplier (5) can be connected to reference potential by the first controllable switch (3);
that the integration capacitor (6b) of the integrator (6) can be bridged by a second controllable switch (6c);
that a controllable compensation device (10, 11) is provided to compensate offset voltages and offset currents of the multiplier (5) and integrator (6);

that the output of the integrator (6) is connected to a zero-voltage comparator (14) whose output is connected to the control input of the compensation device (10, 11); and

that a control unit (13) closes the two switches (3, 6c) at specific intervals of time for a period Δt, and during this period of time Δt the zero-voltage comparator (14) controls the compensation device (10, 11) such that the output voltage of the integrator (6) becomes zero.

2. An electronic electricity meter as claimed in Claim 1, characterised in that the compensation device (10, 11) includes a forwards- backwards counter (10) whose outputs are connected to a resistance network (11) such that the overall resistance of the resistance network (11) is dependent upon the count of the forwards-backwards counter (10), that a terminal point of the resistance network (11) is connected to an input of the integrator (6), that the clock input of the forwards-backwards counter (10) is connected via a locking stage (13m) to a clock signal generator (12), and that the forwards-backwards control input of the forwards-backwards counter is driven by the zero-voltage comparator (14).

3. An electronic electricity meter as claimed in Claim 1 or 2, characterised in that at fixed intervals of time a clock signal generator (12) sets a first flip-flop (13b) whose set output controls the two switches (3, 6c) and the locking stage (13m).

4. An electronic electricity meter as claimed in Claim 1 or 2, characterised in that at fixed intervals of time a clock signal generator (12) sets a first flip-flop (13b),

that the zero-voltage comparator (14) output is connected to a flank detector (13g to 13l),

that the output of the first flip-flop (13b) and the output of the flank detector (13g to 13l) are connected to the inputs of an AND-gate (13c), and

that the output of the AND-gate (13c) is connected to an input of a second flip-flop (13d) which drives the two switches (3, 6c).

5. An electronic electricity meter as claimed in Claim 4, characterised in that the flank detector (13g to 13l) is connected to a first input of a third flip-flop (13f) whose second input is connected via a delay element (13e) to an output of the second flip-flop (13d), that the first output - assigned to the first input of the third flip-flop (13f) controls the locking stage (13m) and that the second output, which is assigned to the second input, is connected to the reset inputs of the first and second flip-flops (13b, 13d).

**Revendications**

1. Compteur électronique d'électricité comportant un multiplicateur (5) et un intégrateur (6) branché en aval ainsi qu'un dispositif de correction de grandeurs résiduelles, qui commande un premier commutateur commandable (30) branché en amont d'une entrée du multiplicateur (5), caractérisé par le fait

qu'au moins une entrée du multiplicateur (5) peut être reliée au potentiel de référence au moyen du premier commutateur commandable (3),

que le condensateur d'intégration (6b) de l'intégrateur (6) peut être shunté par un second commutateur commandable (6c),

qu'il est prévu un dispositif commandable de compensation (10, 11) servant à compenser des tensions résiduelles ou des courants résiduels du multiplicateur (5) et de l'intégrateur (6),

que la sortie de l'intégrateur (6) reliée à un comparateur de tension nulle (14), dont la sortie est reliée à l'entrée de commande du dispositif de compensation (10, 11), et

qu'une unité de commande (13) ferme à des intervalles de temps déterminés et pendant un intervalle de temps Δt les deux commutateurs (3, 6c), auquel cas pendant cet intervalle de temps Δt, le comparateur de tension nulle (14) commande le dispositif de compensation (10, 11) de telle sorte que la tension de sortie de l'intégrateur (6) s'annule.

2. Compteur électronique d'électricité suivant la revendication 1, caractérisé par le fait que le dispositif de compensation (10, 11) comporte un compteur progressif-régressif (10), dont les sorties sont reliées à un réseau de résistances (11) de telle sorte que l'ensemble de la résistance du réseau de résistances (11) dépend de l'état de comptage du compteur progressif-régressif (10), qu'un point de raccordement du réseau de résistance (11) est relié à l'entrée de l'intégrateur (6), que l'entrée de cadence du compteur progressif-régressif (10) est reliée par l'intermédiaire d'un étage de verrouillage (13m) d'un générateur de cadence (12), et que l'entrée de commande de comptage progressif-régressif du compteur progressif-régressif est commandée par le comparateur de tension nulle (14).

3. Compteur électronique d'électricité suivant la revendication 1 ou 2, caractérisé par le fait qu'un générateur de cadence (12) positionne, à des intervalles de temps fixes, une première bascule bistable (13b), dont la sortie de positionnement commande les deux commutateurs (3, 6c) et l'étage de verrouillage (13m).

4. Compteur électronique d'électricité suivant la revendication 1 ou 2, caractérisé par le fait qu'un générateur de cadence (12) positionne à des intervalles de temps fixes une première bascule bistable (13b), qu'un détecteur de flancs (13g à 13l) est branché en aval du comparateur de tension nulle (14), que la sortie de la première bascule bistable (13b) et la sortie du détecteur de flancs (13g à 13l) sont reliées aux entrées d'une porte ET (13c) et que la sortie de la porte ET (13c) est reliée à une entrée d'une seconde bascule bistable (13d), qui commande les deux commutateurs (3, 6c).

5. Compteur électronique d'électricité suivant la revendication 4, caractérisé par le fait que le détecteur de flancs (13g à 13l) est relié à une première entrée d'une troisième bascule bistable (13f), dont la seconde entrée est reliée par l'intermédiaire d'un circuit de retardement (13e) à une sortie de la seconde bascule bistable (13d), que la première sortie, associée à la première entrée, de la troisième bascule bistable (13f) commande l'étage de verrouillage (13m) et que la seconde sortie, associée à la seconde entrée, est reliée aux entrées de remise à l'état initial des première et seconde bascules bistables (13b, 13d).

FIG 1

FIG 2